(19) Europäisches Patentamt
European Patent Office
Office européen des brevets

(11) **EP 3 507 615 B1**

(12) **EUROPÄISCHE PATENTSCHRIFT**

(45) Veröffentlichungstag und Bekanntmachung des Hinweises auf die Patenterteilung:
**13.05.2020 Patentblatt 2020/20**

(21) Anmeldenummer: **17745323.0**

(22) Anmeldetag: **27.07.2017**

(51) Int Cl.:
*G01R 31/36* (2020.01)    *H02J 7/00* (2006.01)

(86) Internationale Anmeldenummer:
**PCT/EP2017/069015**

(87) Internationale Veröffentlichungsnummer:
**WO 2018/041487 (08.03.2018 Gazette 2018/10)**

(54) **VERFAHREN ZUM ÜBERPRÜFEN EINER SYMMETRIERSCHALTUNG**

METHOD FOR TESTING A BALANCED CIRCUIT

PROCÉDÉ DE CONTRÔLE D'UN CIRCUIT D'ÉQUILIBRAGE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **05.09.2016 DE 102016216775**

(43) Veröffentlichungstag der Anmeldung:
**10.07.2019 Patentblatt 2019/28**

(73) Patentinhaber: **Bayerische Motoren Werke Aktiengesellschaft**
**80809 München (DE)**

(72) Erfinder:
• HOLLWEG, Tobias
**110016 Shenyang/Dongling District (CN)**
• SCHWEIGER, Benno
**80337 München (DE)**

(56) Entgegenhaltungen:
DE-A1-102008 048 382    JP-A- 2010 271 267
US-A1- 2011 285 538    US-A1- 2014 253 135

**Beschreibung**

Die vorliegende Erfindung betrifft ein Verfahren gemäß Anspruch 1 eine Vorrichtung gemäß Anspruch 6 und ein Batteriesystem gemäß Anspruch 8, sowie ein Fahrzeug gemäß Anspruch 9.

Ein Elektrofahrzeug oder ein Hybridfahrzeug weist ein Batteriesystem (Hochvoltspeicher) auf, das mehrere in Reihe und/oder parallel geschaltete Batterien bzw. Batteriemodule umfasst, die jeweils mindestens zwei Batteriezellen aufweisen. Der Entladevorgang einer Batterie, die mehrere Batteriezellen aufweist, wird gestoppt, sobald die am schwächsten geladene Batteriezelle der Batterie ihre Minimalspannung erreicht hat, da diese Batteriezelle bei einer weiteren Entladung Schaden nehmen und zerstört werden würde. Gleichermaßen muss der Ladevorgang einer Batterie unterbrochen werden, sobald eine Batteriezelle der Batterie ihre Maximalspannung erreicht hat. Die weitere Aufladung dieser Batteriezelle würde zur Überladung und damit zu einer Zerstörung führen. Nach einer Unterbrechung des Ladevorgangs bzw. des Entladevorgangs werden jedoch die anderen, innerhalb der Batterie in Serie geschalteten Batteriezellen ebenfalls nicht weiter geladen bzw. entladen, obwohl sie möglicherweise noch nicht vollständig geladen bzw. entladen sind. Aus diesem Grund wird der Ladezustand der gesamten Batterie von der Batteriezelle mit der größten beziehungsweise geringsten Batteriezellspannung beschränkt. Daher kann die Gesamtkapazität der Batterie stark beeinträchtigt.

Da der Ladevorgang einer Batterie durch die "vollste" Batteriezelle bzw. der Entladevorgang der Batterie durch die "leerste" Batteriezelle beschränkt ist, weist ein Batteriesystem normalerweise eine Symmetrierschaltung auf, die dazu dient, die Spannungsdifferenz zwischen der "vollste" Batteriezelle und der "leerste" Batteriezelle zu verringern. Um zu überprüfen, ob die Symmetrierschaltung richtig funktioniert, wird der Strom, der über Widerstände der Symmetrierschaltung abfließt, gemäß dem Stand der Technik mittels Stromsensoren gemessen. Wenn nach Aktivierung der Symmetrierschaltung kein Strom über die Widerstände fließt, ist die Symmetrierschaltung als defekt anzusehen. Da zur Überwachung der Widerstände ein Stromsensor für jede einzelne Batteriezelle benötigt ist, werden die Kosten des Batteriesystems wegen der zusätzlichen Kosten der Stromsensoren erhöht. JP 2010 271267 A, US 2014/253135 A1 und US 2011/285538 A1 zeigen bekannte Verfahren um Fehler in einer Batterie mit Symmetrierschaltung zu detektieren.

Aufgabe der vorliegenden Erfindung ist es, ein einfaches und kostengünstig implementierbares Verfahren zum Überprüfen einer Symmetrierschaltung zu schaffen. Aufgabe der Erfindung ist es ferner, eine entsprechende Vorrichtung zum Überprüfen einer Symmetrierschaltung, ein Batteriesystem mit einer solchen Vorrichtung und ein Fahrzeug mit mit einem solchen Batteriesystem zu schaffen.

Diese Aufgabe wird durch die Merkmale des Patentanspruches 1 bzw. 6 bzw. 8 bzw. 9 gelöst.

Vorteilhafte Ausgestaltungen und Weiterbildungen der Erfindung sind den Unteransprüchen zu entnehmen, wobei auch Kombinationen der einzelnen Anspruchsmerkmale untereinander möglich sind.

**Offenbarung der Erfindung**

Das erfindungsgemäße Verfahren zum Überprüfen einer Symmetrierschaltung für eine Batterie, die mehrere Batteriezellen aufweist, umfasst die folgenden Schritte:

    a) Detektieren von ersten Spannungszuständen der Batteriezellen mittels einer Steuereinheit,
    b) Aktivieren der Symmetrierschaltung mit dem Ziel, eine Spannungsangleichung von mindestens zwei der Batteriezellen zu erreichen,
    c) Detektieren von zweiten Spannungszuständen der Batteriezellen mittels der Steuereinheit, und
    d) Bestimmen einer Funktionsfähigkeit der Symmetrierschaltung basierend auf den ersten Spannungszuständen und den zweiten Spannungszuständen der Batteriezellen mittels einer Steuereinheit.

Die Steuereinheit detektiert und vergleicht die Spannungszustände der Batteriezellen vor bzw. nach einem Symmetrierungsvorgang. Funktioniert die Symmetrierschaltung richtig, wird die Spannungsdifferenz zwischen der "vollsten" Batteriezelle und der "leersten" Batteriezelle nach dem Symmetrierungsvorgang verringert. Wenn die Spannungsdifferenz nach dem Symmetrierungsvorgang nicht oder nicht ausreichend verringert ist, ist die Symmetrierschaltung daher als defekt anzusehen.

Das erfindungsgemäße Verfahren weist im Schritt a) folgende Schritte auf: a1) Detektieren einer ersten Gruppe von Spannungen der Batteriezellen mittels der Steuereinheit; und a2) Berechnen einer ersten Spannungsdifferenz zwischen einer höchsten Spannung und einer niedrigsten Spannung der ersten Gruppe von Spannungen mittels der Steuereinheit.

Das erfindungsgemäße Verfahren weist im Schritt c) folgende Schritte auf: c1) Detektieren einer zweiten Gruppe von Spannungen der Batteriezellen; und c2) Berechnen einer zweiten Spannungsdifferenz zwischen einer höchsten Spannung und einer niedrigsten Spannung der zweiten Gruppe von Spannungen mittels der Steuereinheit.

Vorzugsweise können die Spannungen der Batteriezellen mittels eines Voltmeters gemessen werden, ohne zusätzliche Stromsensoren zu verwenden.

Das erfindungsgemäße Verfahren weist im Schritt d) folgende Schritte auf: d1) Berechnen eines Differenzwerts zwischen der ersten Spannungsdifferenz und der zweiten Spannungsdifferenz und Vergleichen des Differenzwerts mit einem vorbestimmten Spannungswert mittels der Steuereinheit; und d2) Bestimmen mittels der Steuereinheit, dass die Symmetrierschaltung nicht funktioniert, wenn der Differenzwert kleiner als ein vorbestimmter Spannungswert ist.

Die Funktionsfähigkeit der Symmetrierschaltung ist dadurch bestimmt, dass die Symmetrierschaltung als defekt anzusehen ist, wenn die Spannungsdifferenz nach dem Symmetrierungsvorgang nicht oder nicht ausreichend, d.h. beispielsweise um mindestens einen vorgegebenen Spannungsmindestwert oder um einen vorgegebenen Prozentsatz der ursprünglichen Spannungsdifferenz, verringert ist.

Nach einer Weiterbildung der Erfindung umfasst das Verfahren einen weiteren Schritt: Bestimmen mittels der Steuereinheit, dass die Symmetrierschaltung funktioniert, wenn der Differenzwert größer als oder gleich dem vorbestimmten Spannungswert ist.

Nach einer Weiterbildung der Erfindung wird der Schritt c1) eine bestimmte Zeit nach dem Schritt a1) durchgeführt.

Nach einer Weiterbildung der Erfindung wird die bestimmte Zeit in Abhängigkeit von einer Zeitdauer der Spannungsangleichung bestimmt; oder die bestimmte Zeit ist ein vorbestimmter Wert. Beispielsweise kann der Schritt c1) die Zeitdauer der Spannungsangleichung z. B. 1 - 10 Stunde nach dem Schritt a1) durchgeführt werden. Alternativ kann die bestimmte Zeit durch das System als z.B. 2 Stunden vorbestimmt werden.

Nach einer Weiterbildung der Erfindung ist der vorbestimmte Spannungswert zwischen 0 mV und 10 mV.

Ferner schlägt die vorliegende Erfindung eine Vorrichtung zum Überprüfen einer Symmetrierschaltung für eine Batterie vor, die mehrere Batteriezellen aufweist. Die Vorrichtung umfasst eine Steuereinheit. Die Vorrichtung detektiert erste Spannungszustände der Batteriezellen und aktiviert die Symmetrierschaltung mit dem Ziel, eine Spannungsangleichung von mindestens zwei der Batteriezellen zu erreichen, und detektiert zweite Spannungszustände der Batteriezellen und bestimmt eine Funktionsfähigkeit der Symmetrierschaltung basierend auf den ersten Spannungszuständen und den zweiten Spannungszuständen der Batteriezellen.

Nach der Erfindung weist die Vorrichtung mindestens ein Voltmeter auf; wobei das mindestens eine Voltmeter eine erste Gruppe von Spannungen der Batteriezellen detektiert; und wobei die Steuereinheit eine erste Spannungsdifferenz zwischen einer höchsten Spannung und einer niedrigsten Spannung der ersten Gruppe von Spannungen berechnet.

Nach der Erfindung detektiert das mindestens eine Voltmeter eine zweite Gruppe von Spannungen der Batteriezellen; wobei die Steuereinheit eine zweite Spannungsdifferenz zwischen einer höchsten Spannung und einer niedrigsten Spannung der zweiten Gruppe von Spannungen berechnet.

Nach der Erfindung berechnet die Steuereinheit einen Differenzwert zwischen der ersten Spannungsdifferenz und der zweiten Spannungsdifferenz und vergleicht den Differenzwert mit einem vorbestimmten Spannungswert, wobei die Steuereinheit bestimmt, dass die Symmetrierschaltung nicht funktioniert, wenn der Differenzwert kleiner als der vorbestimmter Spannungswert ist.

Nach einer Weiterbildung der Erfindung ist der vorbestimmte Spannungswert D4 zwischen 0 mV und 10 mV.

Des Weiteren schlägt die vorliegende Erfindung ein Batteriesystem vor. Das Batteriesystem umfasst mindestens eine Batterie, die mehrere Batteriezellen aufweist, eine Symmetrierschaltung, die ein Ziel aufweist, eine Spannungsangleichung von mindestens zwei der Batteriezellen zu erreichen, und eine oben genannte Vorrichtung.

Des Weiteren schlägt die vorliegende Erfindung ein Elektrofahrzeug oder Hybridfahrzeug mit einem oben genannten Batteriesystem vor.

Da die Spannungen der Batteriezellen bereits durch das Batteriesystem aus anderen Gründen gemessen bzw. überwacht werden, ist es vorteilhaft, dass zum Implementieren der Erfindung kein zusätzliches Bauelement bzw. Sensor notwendig ist. Außerdem kann die erfindungsgemäße Funktion der Steuereinheit in ein bestehendes Steuergerät bzw. einen bestehenden Mikrokontroller implementiert werden. Damit bietet die Erfindung eine Lösung zum Überprüfen einer Symmetrierschaltung an, ohne die Kosten des Batteriesystems zu erhöhen. Des Weiteren verlangt die erfindungsgemäße Vorrichtung keinen weiteren Bauraum, um die Steuereinheit anzuordnen.

Im Folgenden wird die Erfindung im Zusammenhang mit der Zeichnung näher erläutert. Es zeigen:

Fig.1 ein Ablaufdiagramm eines Ausführungsbeispiels des erfindungsgemäßen Verfahrens;

Fig.2 ein weiteres Ablaufdiagramm eines weiteren Ausführungsbeispiels des erfindungsgemäßen Verfahrens; und

Fig.3 eine schematische Darstellung eines Ausführungsbeispiels der erfindungsgemäße Vorrichtung.

Die nachfolgend erläuterten Ausführungsbeispiele stellen bevorzugte Ausführungsformen der vorliegenden Erfindung dar.

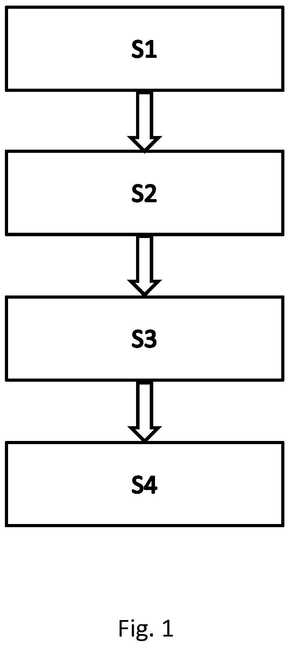

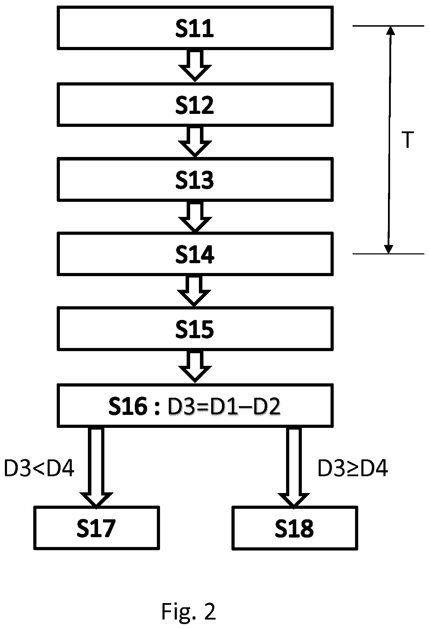

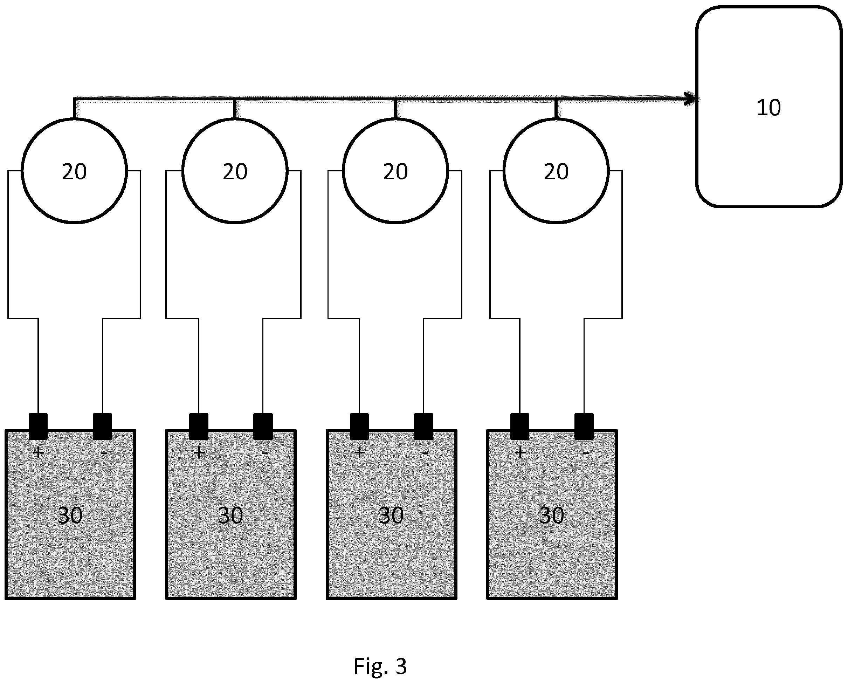

Im Schritt S1 in Fig. 1 werden erste Spannungszustände der Batteriezellen 30 mittels einer Steuereinheit 10 detektiert. Fig. 3 stellt schematisch eine erfindungsgemäße Vorrichtung bzw. die Steuereinheit 10 dar, die das Verfahren in Fig. 1 bzw. das Verfahren in Fig. 2 implementieren kann.

Vorzugsweise kann der Schritt S1 durch den Schritt S11 und den Schritt S12 in Fig. 2 implementiert werden. Im Schritt S11 in Fig. 2 werden eine erste Gruppe von Spannungen der Batteriezellen 30 mittels z.B. mindestens eines Voltmeters, detektiert.

Im Schritt S12 in Fig. 2 wird eine erste Spannungsdifferenz D1 zwischen einer höchsten Spannung und einer niedrigsten Spannung der ersten Gruppe von Spannungen mittels der Steuereinheit 10 berechnet. Die erste Spannungsdifferenz D1 indiziert die Spannungsdifferenz zwischen zwei Batteriezellen 30 der Vielzahl der Batteriezellen 30 vor dem Schritt der Spannungsangleichung bzw. der Symmetrierung der Vielzahl der Batteriezellen 30.

Da die Spannungen der Batteriezellen 30 bereits durch das Batteriesystem (nicht gezeigt) aus anderen Gründen gemessen bzw. überwacht werden, werden keine zusätzlichen Bauelemente bzw. Sensoren benötigt, um die Spannungen der Batteriezellen 30 zu detektieren.

Im Schritt S2 ist die Symmetrierschaltung aktiviert. Wie oben erwähnt hat die Symmetrierschaltung die Aufgabe, eine Spannungsangleichung von mindestens zwei der Batteriezellen 30 zu erreichen. Die Symmetrierschaltung dient also zum "Balancing" bzw. zur Angleichung der Ladezustände von Batteriezellen 30 eines Batteriesystems, welches mindestens zwei Batteriezellen 30 aufweist. Eine Symmetrierschaltung ist einer Batteriezelle oder einem Batteriemodul zugeordnet und mit dieser verbunden.

Der Symmetrierungsvorgang umfasst die folgenden Verfahrensschritte: Ermitteln der Batteriezellenspannungen; Identifizieren einer Batteriezelle mit der geringsten Spannung; Überführen der Symmetrierschaltung der Batteriezelle mit der geringsten Batteriezellspannung von einem aktiven Zustand in einen Schlafmodus; Betreiben der Symmetrierschaltung im aktiven Zustand, die mit Batteriezellen 30 verbunden ist, deren Batteriezellenspannungen jeweils größer als die geringste Batteriezellenspannung sind; Überführen von im aktiven Zustand betriebenen Symmetrierschaltung in den Schlafmodus, sobald die jeweilige Batteriezellenspannung der jeweils der Symmetrierschaltung im aktiven Zustand zugeordneten Batteriezellen 30 jeweils gleich der geringsten Batteriemodulspannung der Vielzahl der Batteriezellen 30 ist.

Im Schritt S3 werden zweite Spannungszustände der Batteriezellen 30 mittels der Steuereinheit 10 detektiert.

Vorzugsweise kann der Schritt S3 durch den Schritt S14 und den Schritt S15 in Fig. 2 implementiert werden. Im Schritt S14 in Fig. 2 wird eine zweite Gruppe von Spannungen der Batteriezellen 30 mittels z.B. mindestens eines Voltmeters, detektiert. Im Schritt S15 in Fig. 2 ist eine zweite Spannungsdifferenz D2 zwischen einer höchsten Spannung und einer niedrigsten Spannung der zweiten Gruppe von Spannungen mittels der Steuereinheit 10 berechnet. Die zweite Spannungsdifferenz D2 indiziert die größte Spannungsdifferenz zwischen zwei Batteriezellen 30 der Vielzahl der Batteriezellen 30 nach der Symmetrierung der Vielzahl der Batteriezellen 30. Die zweite Gruppe von Spannungen der Batteriezellen 30 wird eine bestimmte Zeit T nach dem Detektieren der ersten Gruppe von Spannungen der Batteriezellen 30 bzw. dem Schritt S11 detektiert, wobei die bestimmte Zeit T in Abhängigkeit von einer Zeitdauer der Spannungsangleichung bzw. Symmetrierung bestimmt wird oder ein vorbestimmter Wert ist.

Entsprechend dem Prinzip der Symmetrierung wird die Spannung der Batteriezelle, die eine höchste Spannung vor der Symmetrierung der Vielzahl der Batteriezellen 30 aufweist, durch die Symmetrierung verkleinert, wenn die Symmetrierschaltung funktioniert. Deswegen soll die größte Spannungsdifferenz D2 zwischen einer höchsten Spannung und einer niedrigsten Spannung der Vielzahl der Batteriezellen 30 nach der Symmetrierung der Vielzahl der Batteriezellen 30 verringert werden, wenn die Symmetrierschaltung funktioniert, d.h. die zweite Spannungsdifferenz D2 soll kleiner als die erste Spannungsdifferenz D1 sein.

Im Schritt S4 in Fig. 1 wird eine Funktionsfähigkeit der Symmetrierschaltung basierend auf den ersten Spannungszuständen und den zweiten Spannungszuständen der Batteriezellen 30 mittels der Steuereinheit 10 bestimmt.

Vorzugsweise kann der Schritt S4 durch den Schritt S16 und den Schritt S17 in Fig. 2 implementiert werden. Im Schritt S16 wird ein Differenzwert D3 zwischen der ersten Spannungsdifferenz D1 und der zweiten Spannungsdifferenz D2 durch die folgende Gleichung berechnet:

$$D3 = D1 - D2.$$

Im Schritt S16 vergleicht die Steuereinheit 10 den Differenzwert D3 ferner mit einem vorbestimmten Spannungswert D4 und bestimmt im Schritt S17, dass die Symmetrierschaltung nicht funktioniert, wenn der Differenzwert D3 kleiner als ein vorbestimmter Spannungswert D4 ist. Der vorbestimmte Spannungswert D4 ist zwischen 0 mV und 10 mV eingestellt. Vorzugsweise ist der vorbestimmte Spannungswert D4 4 mV.

Des Weiteren kann die Steuereinheit im Schritt S18 in Fig. 2 bestimmen, dass die Symmetrierschaltung funktioniert, wenn der Differenzwert D3 größer als oder gleich dem vorbestimmten Spannungswert D4 ist.

Die Steuereinheit kann die Funktionsfähigkeit der Symmetrierschaltung basierend auf dem Differenzwert D3 und den vorbestimmten Spannungswerten bzw. Bereichen stufenweise bewerten, z.B. "sehr gut funktioniert", "ausreichend", "schlecht" und "defekt".

Das bestehende Steuergerät bzw. Mikrokontroller innerhalb des Batteriesystems kann als die Steuereinheit dienen. Dies führt zu keinem zusätzlichen Aufwand. Damit bietet die vorliegende Erfindung eine Lösung zum Überprüfen einer Symmetrierschaltung an, ohne die Kosten des Batteriesystems zu erhöhen.

Fig. 3 zeigt eine schematische Darstellung einer erfindungsgemäßen Vorrichtung, die eine Symmetrierschaltung für eine Batterie, die mehrere Batteriezellen 30 aufweist, überprüfen kann. Die Vorrichtung umfasst eine Steuereinheit 10 und mehrere Voltmeter 20, wobei die Vorrichtung erste Spannungszustände der Batteriezellen 30 detektiert und die Symmetrierschaltung (nicht gezeigt) aktiviert mit dem Ziel, eine Spannungsangleichung von mindestens zwei der Batteriezellen 30 zu erreichen, und zweite Spannungszustände der Batteriezellen 30 detektiert, und eine Funktionsfähigkeit der Symmetrierschaltung basierend auf den ersten Spannungszuständen und den zweiten Spannungszuständen der Batteriezellen 30 bestimmt.

Die Voltmeter 20 dienen dazu, die Spannungen der Batteriezellen 30 zu messen. Die Steuereinheit 10 berechnet eine erste Spannungsdifferenz D1 zwischen einer höchsten Spannung und einer niedrigsten Spannung der Batteriezellen 30 vor dem Schritt der Symmetrierung und eine zweite Spannungsdifferenz D2 zwischen einer höchsten Spannung und einer niedrigsten Spannung der Batteriezellen 30 nach der Symmetrierung. Da die Spannungen der Batteriezellen 30 bereits durch das Batteriesystem aus anderen Gründen gemessen bzw. überwacht werden, sind die Voltmeter innerhalb eines Batteriesystems bereits vorhanden. Daher sind keine zusätzlichen Bauelemente benötigt, um die Spannungen der Batteriezellen 30 zu messen.

Die Steuereinheit 10 berechnet einen Differenzwert D3 zwischen der ersten Spannungsdifferenz D1 und der zweiten Spannungsdifferenz D2 und vergleicht den Differenzwert D3 mit einem vorbestimmten Spannungswert D4. Die Steuereinheit 10 bestimmt, dass die Symmetrierschaltung nicht funktioniert, wenn der Differenzwert D3 kleiner als ein vorbestimmter Spannungswert D4 ist. Andererseits funktioniert die Symmetrierschaltung, wenn der Differenzwert D3 größer als oder gleich dem vorbestimmten Spannungswert D4 ist.

Ein bereits vorhandenes Steuergerät bzw. ein bereits vorhandener Mikrokontroller des Batteriesystems kann als die Steuereinheit dienen. Daher führt dies zu keinem zusätzlichen Aufwand. Damit bietet die vorliegende Erfindung eine Lösung zum Überprüfen einer Symmetrierschaltung an, ohne die Kosten des Batteriesystems zu erhöhen. Da keine zusätzlichen Bauelemente eingesetzt werden müssen, bleibt der Bauraum des Batteriesystems unverändert.

**Patentansprüche**

1. Verfahren zum Überprüfen einer Symmetrierschaltung für eine Batterie, die mehrere Batteriezellen aufweist, mit folgenden Schritten:

   a) Detektieren (S1) von ersten Spannungszuständen der Batteriezellen mittels einer Steuereinheit (10),
   b) Aktivieren (S2) der Symmetrierschaltung mit dem Ziel, eine Spannungsangleichung von mindestens zwei der Batteriezellen zu erreichen,
   c) Detektieren (S3) von zweiten Spannungszuständen der Batteriezellen mittels der Steuereinheit (10), und
d) Bestimmen (S4) einer Funktionsfähigkeit der Symmetrierschaltung basierend auf den ersten Spannungszuständen und den zweiten Spannungszuständen der Batteriezellen mittels der Steuereinheit (10);

wobei der Schritt a) aufweist:

   a1) Detektieren (S11) einer ersten Gruppe von Spannungen der Batteriezellen; und
   a2) Berechnen (S12) einer ersten Spannungsdifferenz (D1) zwischen einer höchsten Spannung und einer niedrigsten Spannung der ersten Gruppe von Spannungen mittels der Steuereinheit (10);

wobei der Schritt c) aufweist:

   c1) Detektieren (S14) einer zweiten Gruppe von Spannungen der Batteriezellen; und
   c2) Berechnen (S15) einer zweiten Spannungsdifferenz (D2) zwischen einer höchsten Spannung und einer niedrigsten Spannung der zweiten Gruppe von Spannungen mittels der Steuereinheit (10); und

wobei der Schritt d) aufweist:

   d1) Berechnen (S16) eines Differenzwerts (D3) zwischen der ersten Spannungsdifferenz (D1) und der zweiten Spannungsdifferenz (D2) und Vergleichen (S16) des Differenzwerts (D3) mit einem vorbestimmten Spannungswert (D4) mittels der Steuereinheit (10); und
   d2) Bestimmen (S17) mittels der Steuereinheit (10), dass die Symmetrierschaltung nicht funktioniert, wenn der Differenzwert (D3) kleiner als ein vorbestimmter Spannungswert (D4) ist.

2. Verfahren nach Anspruch 1, wobei das Verfahren weiter umfasst: Bestimmen (S18) mittels der Steuereinheit (10), dass die Symmetrierschaltung funktioniert, wenn der Differenzwert (D3) größer als oder gleich zu dem vorbestimmten Spannungswert (D4) ist.

3. Verfahren nach einem der Ansprüche 1 - 2, wobei der Schritt c1) eine bestimmte Zeit (T) nach dem Schritt a1) durchgeführt wird.

4. Verfahren nach Anspruch 3, wobei die bestimmte Zeit (T) in Abhängigkeit von einer Zeitdauer der Spannungsangleichung bestimmt wird; oder wobei die bestimmte Zeit (T) ein vorbestimmter Wert ist.

**5.** Verfahren nach einem der Ansprüche 1 - 4, wobei der vorbestimmte Spannungswert (D4) zwischen 0 mV und 10 mV ist.

**6.** Vorrichtung zum Überprüfen einer Symmetrierschaltung für eine Batterie, die mehrere Batteriezellen aufweist, umfassend eine Steuereinheit (10); wobei die Vorrichtung konfiguriert ist

- erste Spannungszustände der Batteriezellen zu detektieren,
- die Symmetrierschaltung zu aktivieren mit dem Ziel, eine Spannungsangleichung von mindestens zwei der Batteriezellen zu erreichen,
- zweite Spannungszustände der Batteriezellen zu detektieren, und
- eine Funktionsfähigkeit der Symmetrierschaltung basierend auf den ersten Spannungszuständen und den zweiten Spannungszuständen der Batteriezellen zu bestimmen;

wobei die Vorrichtung mindestens ein Voltmeter (20) aufweist;

wobei das mindestens eine Voltmeter (20) konfiguriert ist eine erste Gruppe von Spannungen der Batteriezellen zu detektieren; und

wobei die Steuereinheit (10) konfiguriert ist eine erste Spannungsdifferenz (D1) zwischen einer höchsten Spannung und einer niedrigsten Spannung der ersten Gruppe von Spannungen zu berechnen;

wobei das mindestens eine Voltmeter (20) konfiguriert ist eine zweite Gruppe von Spannungen der Batteriezellen zu detektieren; und

wobei die Steuereinheit (10) konfiguriert ist eine zweite Spannungsdifferenz (D2) zwischen einer höchsten Spannung und einer niedrigsten Spannung der zweiten Gruppe von Spannungen zu berechnen; und

wobei die Steuereinheit (10) konfiguriert ist einen Differenzwert (D3) zwischen der ersten Spannungsdifferenz (D1) und der zweiten Spannungsdifferenz (D2) zu berechnen und den Differenzwert (D3) mit einem vorbestimmten Spannungswert (D4) zu vergleichen; und

wobei die Steuereinheit (10) konfiguriert ist zu bestimmen, dass die Symmetrierschaltung nicht funktioniert, wenn der Differenzwert (D3) kleiner als der vorbestimmte Spannungswert (D4) ist.

**7.** Vorrichtung nach Anspruch 6, wobei der vorbestimmte Spannungswert (D4) zwischen 0 mV und 10 mV ist.

**8.** Batteriesystem umfassend mindestens eine Batterie, die mehrere Batteriezellen aufweist, und eine Symmetrierschaltung, die ein Ziel aufweist, eine Spannungsangleichung von mindestens zwei der Batteriezellen zu erreichen,

**dadurch gekennzeichnet, dass** das Batteriesystem eine Vorrichtung gemäß einem der Ansprüche 6 - 7 aufweist.

**9.** Elektrofahrzeug oder Hybridfahrzeug mit einem Batteriesystem gemäß Anspruch 8.

**Claims**

**1.** A method for testing a balancing circuit for a battery that has a plurality of battery cells, the method comprising the steps of:

a) detecting (S1) first voltage states of the battery cells by means of a control unit (10) ;
b) activating (S2) the balancing circuit with the objective of achieving voltage equalisation of at least two of the battery cells;
c) detecting (S3) second voltage states of the battery cells by means of the control unit (10); and
d) determining (S4) a functional capability of the balancing circuit on the basis of the first voltage states and the second voltage states of the battery cells, by means of the control unit (10);

wherein step a) comprises:

a1) detecting (S11) a first group of voltages of the battery cells; and
a2) calculating (S12) a first voltage difference (D1) between a highest voltage and a lowest voltage of the first group of voltages by means of the control unit (10);

wherein step c) comprises the steps of:

c1) detecting (S14) a second group of voltages of the battery cells; and
c2) calculating (S15) a second voltage difference (D2) between a highest voltage and a lowest voltage of the second group of voltages by means of the control unit (10); and

wherein step d) comprises the steps of:

d1) calculating (S16) a difference value (D3) between the first voltage difference (D1) and the second voltage difference (D2) and comparing (S16) the difference value (D3) with a predetermined voltage value (D4) by means of the control unit (10); and
d2) determining (S17), by means of the control unit (10), that the balancing circuit is not working if the difference value (D3) is smaller than a predetermined voltage value (D4) .

**2.** A method according to claim 1, wherein the method further comprises the step of:

determining (S18), by means of the control unit (10), that the balancing circuit is working if the difference value (D3) is greater than or equal to the predetermined voltage value (D4).

**3.** A method according to one of claims 1 to 2, wherein step c1) is performed a specific time (T) after step a1).

**4.** A method according to claim 3, wherein the specific time (T) is determined depending on a duration of the voltage equalisation; or wherein the specific time (T) is a predetermined value.

**5.** A method according to one of claims 1 to 4, wherein the predetermined voltage value (D4) is between 0 mV and 10 mV.

**6.** A device for testing a balancing circuit for a battery that has a plurality of battery cells, comprising a control unit (10); wherein the device is configured

- to detect first voltage states of the battery cells
- to activate the balancing circuit with the objective of achieving voltage equalisation of at least two of the battery cells,
- to detect second voltage states of the battery cells, and
- to determine a functional capability of the balancing circuit on the basis of the first voltage states and the second voltage states of the battery cells,

the device comprising at least one voltmeter (20) ;
the at least one voltmeter (20) being configured to detect a first group of voltages of the battery cells; and
the control unit (10) being configured to calculate a first voltage difference (D1) between a highest voltage and a lowest voltage of the first group of voltages;
the at least one voltmeter (20) being configured to detect a second group of voltages of the battery cells, and
the control unit (10) being configured to calculate a second voltage difference (D2) between a highest voltage and a lowest voltage of the second group of voltages; and
the control unit (10) being configured to calculate a difference value (D3) between the first voltage difference (D1) and the second voltage difference (D2) and to compare the difference value (D3) with a predetermined voltage value (D4); and
the control unit (10) being configured to determine that the balancing circuit is not working if the difference value (D3) is smaller than the predetermined voltage value (D4) .

**7.** A device according to claim 6, wherein the predetermined voltage value (D4) is between 0 mV and 10 mV.

**8.** A battery system comprising at least one battery, which has a plurality of battery cells, and a balancing circuit of which the purpose is to achieve voltage equalisation of at least two of the battery cells, **characterised in that** the battery system comprises a device according to one of claims 6 to 7.

**9.** An electric vehicle or hybrid vehicle comprising a battery system according to claim 8.

**Revendications**

**1.** Procédé de contrôle d'un circuit d'équilibrage destiné à une batterie qui comporte plusieurs cellules de batterie, comprenant les étapes suivantes consistant à :

a) détecter (S1) des premiers états de tension des cellules de batterie au moyen d'une unité de commande (10),
b) activer (S2) le circuit d'équilibrage dans le but d'obtenir un équilibrage de tension d'au moins deux des cellules de batterie,
c) détecter (S3) des seconds états de tension des cellules de batterie au moyen de l'unité de commande (10),
d) déterminer (S4) l'aptitude au fonctionnement du circuit d'équilibrage sur le fondement des premiers états de tension et des seconds états de tension des cellules de batterie au moyen de l'unité de commande (10),

l'étape a) comprenant les sous étapes suivantes consistant à :

a1) détecter (S11) un premier groupe de tensions des cellules de batterie, et
a2) calculer (S12) une première différence de tension (D1) entre la tension la plus haute et la tension la plus basse du premier groupe de tensions au moyen de l'unité de commande (10),

l'étape c) comprenant les sous étapes suivantes consistant à :

c1) détecter (S14) un second groupe de tensions des cellules de batterie, et
c2) calculer (S15) une seconde différence de tension (D2) entre la tension la plus haute et la tension la plus basse du second groupe de tensions au moyen de l'unité de commande (10), et

l'étape d) comprenant les sous étapes suivantes consistant à :

d1) calculer (S16) la valeur de la différence (D3) entre la première différence de tension (D1) et la seconde différence de tension (D2), et comparer (S16) la valeur de la différence (D3) avec une valeur de tension (D4) prédéfinie au moyen de l'unité de commande (10), et
d2) déterminer (S17) au moyen de l'unité de commande (10) que le circuit d'équilibrage ne fonctionne pas lorsque la valeur de la différence (D3) est inférieure à une valeur de tension (D4) prédéfinie.

2. Procédé conforme à la revendication 1, comportant en outre une étape consistant à : déterminer (S18) au moyen de l'unité de commande (10) que le circuit d'équilibrage fonctionne lorsque la valeur de la différence (D3) est supérieure ou égale à la valeur de tension (D4) prédéfinie.

3. Procédé conforme à l'une des revendications 1 et 2, selon lequel la sous étape (c1) est mise en œuvre à un temps déterminé (T) après la sous étape a1).

4. Procédé conforme à la revendication 3, selon lequel le temps (T) est déterminé en fonction de la durée de l'équilibrage de tension ou a une valeur prédéfinie.

5. Procédé conforme à l'une des revendications 1 à 4, selon lequel la valeur de tension (D4) prédéfinie est située entre 0 mV et 10 mV.

6. Dispositif permettant de contrôler un circuit d'équilibrage destiné à une batterie qui comporte plusieurs cellules de batterie, comprenant une unité de commande (10), ce procédé étant réalisé pour :

- détecter des premiers états de tension des cellules de batterie,
- activer le circuit d'équilibrage dans le but d'obtenir un équilibrage de tension d'au moins deux cellules de batterie,
- détecter des seconds états de tension des cellules de batterie, et
- déterminer l'aptitude au fonctionnement du circuit d'équilibrage sur le fondement des premiers états de tension et des seconds états de tension des cellules de batterie,

le dispositif comprenant au moins un voltmètre (20), ce voltmètre (20) étant réalisé pour détecter un premier groupe de tensions des cellules de batterie, et l'unité de commande (10) étant réalisée pour calculer une première différence de tension (D1) entre la tension la plus haute et la tension la plus basse du premier groupe de tensions,
le voltmètre (20) état réalisé pour permettre de détecter un second groupe de tensions des cellules de batterie,
l'unité de commande (10) étant réalisée pour calculer une seconde différence de tension (D2) entre la tension la plus haute et la tension la plus basse du second groupe de tensions,
l'unité de commande (10) étant réalisée pour permettre de calculer la valeur de la différence de tension (D3) entre la première différence de tension (D1) et la seconde différence de tension (D2) et de comparer la valeur de la différence (D3) avec une valeur de tension (D4) prédéfinie, et
l'unité de commande (10) étant réalisée pour déterminer que le circuit d'équilibrage ne fonctionne pas lorsque la valeur de la différence de tension (D3) est inférieure à la valeur de tension (D4) prédéfinie.

7. Dispositif conforme à la revendication 6, dans lequel la valeur de tension (D4) prédéfinie est située entre 0 mV et 10 mV.

8. Système de batterie comportant au moins une batterie qui comporte plusieurs cellules de batterie et un circuit d'équilibrage ayant pour fonction d'obtenir un équilibrage de tension d'au moins deux des cellules de batterie,
**caractérisé en ce que**
le système de batterie comporte un dispositif conforme à l'une des revendications 6 et 7.

9. Véhicule électrique ou véhicule hybride ayant un système de batterie conforme à la revendication 8.

Fig. 1

Fig. 2

Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- JP 2010271267 A
- US 2014253135 A1
- US 2011285538 A1